# EUROPÄISCHE PATENTSCHRIFT

(11) **EP 2 124 517 B1**
(45) Veröffentlichungstag und Bekanntmachung des Hinweises auf die Patenterteilung: **15.01.2020**
(21) Anmeldenummer: 09004638.4
(22) Anmeldetag: 31.03.2009
(51) Int. Cl.: H05K 7/20, B60K 6/28, B60K 6/46, B60L 50/40, B60L 58/22, B60L 58/26, B60K 6/20, B60K 1/00, B60W 10/24

(54) **Elektrisches Speichersystem mit Doppelschichtkondensatoren**
Electric storage system with double layer condensators
Système de stockage électrique doté de condensateur à double couche

(30) Priorität: 23.05.2008 DE 102008024912
(43) Veröffentlichungstag der Anmeldung: 25.11.2009
(73) Patentinhaber: MAN Truck & Bus SE, 80995 München (DE)
(72) Erfinder: Kerschl, Stefan, 85402 Kranzberg (DE); Kirchensteiner, Elmar, 85256 Vierkirchen (DE)
(74) Vertreter: v. Bezold & Partner Patentanwälte - PartG mbB

(56) Entgegenhaltungen:
- DE-A1-102004 000 035
- US-A1- 2004 150 926
- US-A1- 2006 241 876
- US-A1- 2008 076 011
- JORG LOTT: "Einsatz des Doppelschitkondensators als zusatzspeicher im Elektrofahrzeug", FORTSCHRITT-BERICHTE V D I. REIHE 21: ELEKTROTECHNIK, VDI VERLAG, DUESSELDORF, DE, Bd. 21, Nr. 307, 7. Dezember 2000 (2000-12-07), Seiten 1-6, XP003025769, ISSN: 0178-9481 ISBN: 978-3-18-330721-0

## Beschreibung

Die vorliegende Erfindung bezieht sich auf ein elektrisches Speichersystem mit Doppelschichtkondensatoren. Dieses Speichersystem kann insbesondere in Kraftfahrzeugen angewendet werden, darüber hinaus ist jedoch auch eine Anwendung in anderen Bereichen möglich.

Sogenannte Doppelschichtkondensatoren, welche auch als elektrochemische Doppelschichtkondensatoren oder Superkondensatoren bezeichnet werden, weisen eine für Kondensatoren sehr hohe Energiedichte auf. Ihre hohe Kapazität basiert auf der Dissoziation von Ionen in einem flüssigen Elektrolyt, die ein Dielektrikum von wenigen Atomlagen bilden und eine große Elektrodenoberfläche aufweisen. Diese Doppelschichtkondesatorspeicher haben sich neuerdings als Hochleistungsspeicher für den mobilen Bereich, beispielsweise zur Nutzung der Bremsenergie, durchgesetzt. In der Regel bestehen diese Speicher aus einer Vielzahl von Einzelkondensatorzellen. Weiterhin eignen sich solche Doppelschichtkondensatoren als Ersatz für Akkumulatoren, wenn eine hohe Zuverlässigkeit und ein häufiges Laden und Entladen gefordert wird. Dabei ist es auch möglich, derartige Kondensatoren als Energiequelle für kleinere Elektrofahrzeuge einzusetzen.

Die Veröffentlichung "Einsatz des Doppelschichtkondensators als Zusatzspeicher im Elektrofahrzeug" von Jörg Lott, Fortschritt-Berichte VDI, Reihe 21: Elektrotechnik, VDI Verlag, Düsseldorf, Deutschland, Band 21, Nummer 307, 7. Dezember 2000 offenbart einen Kurzzeitspeicher mit 105 Doppelschichtkondensatoren, die in Serie verschaltet sind.

Die US 2004/150926 A1 offenbart eine Ultrakondensator-Energiespeicherzellenpackung mit einer Vielzahl von parallelen Ultrakondensatoren und Ausgleichswiderständen in Reihe, einem Gehäuse, einer Steuerung, einem oder mehreren Temperatursensoren und einem Spannungssensor.

Die US 2008/076011 A1 offenbart eine Speicherbatterievorrichtung, die den Zustand einer Temperaturerfassungseinheit und einer Kühleinheit bestimmen kann. In der Speicherbatterievorrichtung, die ein Batteriemodul mit einer oder mehreren Batterien, einer Mehrzahl von Temperaturerfassungseinheiten und einer Kühleinheit umfasst, die das Batteriemodul kühlt, messen die Temperaturerfassungseinheiten zumindest die Temperatur des in die Speicherbatterievorrichtung eingegebenen Kühlmediums, die Temperatur des von der Speicherbatterievorrichtung ausgegebenen Kühlmediums und die Temperatur von mindestens einer der Batterien und des Batteriemoduls.

Die US 2006/241876 A1 offenbart ein Verfahren und eine Vorrichtung zum automatischen Überwachen und Steuern verschiedener Parameter einzelner Ultrakondensatorzellen . Diese Parameter werden überwacht und ein Ersatzladestrom wird an jede Zelle geliefert, die sich extern oder intern entladen hat.

Die DE 10 2004 000035 A1 offenbart zudem ein Diagnoseverfahren zur Bestimmung des Alterungszustandes eines Fahrzeugkondensators zur Speicherung elektrischer Energie durch mindestens einen Entladungsvorgang.

Insbesondere, wenn eine Vielzahl von Zellen in einem Speichersystem verwendet wird, kann es jedoch aufgrund von Fertigungstoleranzen oder anderen statistischen Schwankungen zu Abweichungen einzelner Doppelschichtkondensatoren von einem Sollzustand kommen. Derartige Abweichungen können, falls hierauf keine Gegenreaktion erfolgt, zu einem frühzeitigen Ausfall des vollständigen Speichersystems führen.

Der vorliegenden Erfindung liegt daher die Aufgabe zugrunde, die Lebensdauer von derartigen elektrischen Speichersystemen zu erhöhen. Weiterhin liegt der vorliegenden Erfindung die Aufgabe zugrunde, die Belastbarkeit derartiger elektrischer Speichersysteme zu erhöhen und auch den Einsatz derartiger Systeme flexibler zu gestalten.

Dies wird erfindungsgemäß durch ein elektrisches Speichersystem nach Anspruch 1 erreicht. Vorteilhafte Ausführungsformen und Weiterbildungen sind Gegenstand der Unteransprüche.

Ein erfindungsgemäßes elektrisches Speichersystem weist eine Vielzahl von elektrischen Doppelschichtkondensatoren auf, die elektrisch miteinander verbunden sind. Weiterhin ist eine Überwachungseinrichtung zum Überwachen wenigstens eines physikalischen Zustands der Doppelschichtkondensatoren vorgesehen. Erfindungsgemäß ist das Speichersystem in mehrere Module segmentiert, wobei jedes dieser Module eine Vielzahl von elektrisch miteinander verbundenen Doppelschichtkondensatoren aufweist und die Überwachungseinrichtung weist eine Vielzahl von Spannungsmesseinrichtungen auf, wobei im Wesentlichen jedes Modul mit wenigstens einer Spannungsmesseinrichtung in Verbindung steht, welche einen Spannungszustand dieses Moduls bestimmt.

Zur Überwachung der Doppelschichtkondensatoren wird daher ein Managementsystem vorgeschlagen, welches die spezifischen Eigenschaften der elektrischen Doppelschichtkondensatoren (in Folgenden in EDLC) berücksichtigt. Dieses Managementsystem erlaubt die Überwachung und Konditionierung eines vielzelligen EDLC-Speichersystems.

Durch die Unterteilung einer Vielzahl von Doppelschichtkondensatoren in mehrere Module wird daher ermöglicht, dass Messungen nicht an jedem einzelnen Doppelschichtkondensator vorgenommen werden müssen, sondern jeweils an dem gesamten Modul. Durch diese Segmentierung des Gesamtspeichers in die Teileinheiten bzw. Module kann insgesamt eine Reduzierung der nötigen Messstellen erfolgen. Bevorzugt wird dabei eine potenzialgetrennte Spannungserfassung beschrieben.

Bevorzugt weist das Speichersystem eine Vielzahl von Temperaturmesseinrichtungen auf, wobei jedem Modul wenigstens eine Temperaturmesseinrichtung zugeordnet ist, welche eine für das Modul charakteristische Temperatur bestimmt.

Bei dieser bevorzugten Ausführungsform werden daher neben den Spannungen auch die Modultemperaturen erfasst, wobei vorzugsweise die Modultemperaturen in den jeweils heißesten Bereichen (Hot Spots) erfasst werden.

Bei einer weiteren vorteilhaften Ausführungsform weist das Speichersystem eine Vielzahl von unabhängig voneinander steuerbaren Kühleinrichtungen auf, wobei jedem Modul wenigstens eine Kühleinrichtung zu deren Kühlung zugeordnet ist. Damit ist es möglich, die einzelnen Module separat bedarfsgerecht zu kühlen. So ist es beispielsweise auch möglich, dass neben den Modultemperaturen auch eine Außentemperatur erfasst wird und auch auf Grundlage dieses Temperaturwertes die Modulkühleinrichtungen angesteuert werden. Vorzugsweise handelt es sich bei diesen Kühleinrichtungen um aktive Luftkühlungen wie beispielsweise einzelne Ventilatoren je Modul.

Bei einer weiteren vorteilhaften Ausführungsform weist das Speichersystem eine Prozessoreinrichtung auf, welche aus einer Vielzahl von den Temperaturmesseinrichtungen ausgegebenen Temperaturwerten wenigstens einen Kennwert für das Speichersystem oder einzelne Module ermittelt. So ist es beispielsweise möglich, nicht nur die Modultemperatur und die Außentemperatur zu erfassen, sondern auch einen Temperaturmittelwert zu bestimmen. Auch können insbesondere auf Basis dieses Temperaturmittelwertes individuelle Modultemperaturabweichungen von diesem Mittelwert bestimmt werden und gegebenenfalls in Reaktion auf derartige Abweichungen einzelne Kühleinrichtungen aktiviert werden.

Bei einer weiteren vorteilhaften Ausführungsform weist das Speichersystem eine Steuereinrichtung auf, welche die Kühleinrichtungen in Abhängigkeit von den Temperaturmesseinrichtungen ausgegebenen Werten steuert. So können, wie oben erwähnt einzelne Module bei Bedarf separat gekühlt werden.

Bei einer weiteren vorteilhaften Ausführungsform weist das Speichersystem eine Spannungssymmetrierungseinrichtung auf. Derartige Spannungssymmetrierungseinrichtungen werden eingesetzt, um Spannungs- bzw. Potentialdifferenzen in unterschiedlichen Zelen auszugleichen. Dabei ist es möglich, dass die einzelnen Spannungen der Module erfasst werden und in Reaktion auf voneinander abweichende Spannungen eine Spannungssymmetrierung erfolgt. Dabei kann es sich sowohl um eine passive Spannungssymmetrierung handeln als auch um eine aktive (beispielsweise durch Transistoren geschaltete) Spannungssymmetrierung. Diese Spannungssymmetrierungseinrichtung kann in Reaktion auf erfasste Zellspannungen aktiviert werden.

Bei einer weiteren vorteilhaften Ausführungsformweist das Speichersystem einen an die gesamten Module zuschaltbaren Verbraucher auf. Bei diesem Verbraucher kann es sich beispielsweise um einen mit einem Schaltelement zuschaltbaren Lastwiderstand handeln. Dieses optionale Schaltelement, bei dem es sich auch um einen Leistungshalbleiter handeln kann, dient zur gezielten Erzeugung eines Leistungssprungs. Über den dadurch verursachten Spannungsabfall in den einzelnen Modulen kann für jedes Modul der jeweilige Innenwiderstand und die Kapazität ermittelt werden. Diese Werte können wiederum herangezogen werden, um eine Lebenserwartung (state of health = SOH) des jeweiligen Moduls zu ermitteln. Auf diese Weise wird insbesondere ein gezielter Lastsprung erzeugt. Über den dadurch verursachten Spannungsabfall an den einzelnen Modulen kann für jedes Modul der jeweilige Innenwiderstand und die Kapazität ermittelt werden. Diese Messwerte können für die Bestimmung des Alterungszustandes herangezogen werden.

Die vorliegende Erfindung ist weiterhin auf ein Verfahren zum Steuern eines elektrischen Speichersystems der oben beschriebenen Art gerichtet. Dabei werden mehrere an unterschiedlichen Modulen dieses Speichersystems anliegende Spannungen gemessen und unter Berücksichtigung dieser Spannungen wird wenigstens ein Betriebsparameter des Speichersystems gesteuert. Unter einem Betriebsparameter des Speichersystems kann dabei beispielsweise die Leistungsabgabe des Speichersystems verstanden werden. Daneben kann es sich jedoch bei dem Betriebsparameter des Speichersystems auch um eine Gesamttemperatur des Systems oder um eine Temperatur einzelner Module handeln. Damit wird auch bei dem erfindungsgemäßen Verfahren vorgeschlagen, in Abhängigkeit von gemessenen Spannungswerten der einzelnen Module Betriebsparameter des Speichersystems zu beeinflussen, beispielsweise die Temperatur einzelner Module zu verändern.

Vorzugsweise werden auch die Temperaturen mehrerer Module gemessen und unter Berücksichtigung dieser Temperaturen wenigstens ein Betriebsparameter des Speichersystems gesteuert. Damit wird der erwähnte Betriebsparameter nicht nur in Abhängigkeit von den Spannungen sondern auch in Abhängigkeit von den Temperaturen der einzelnen Module gesteuert.

Bei einer weiteren vorteilhaften Ausführungsform wird unter Berücksichtigung sowohl mindestens einer Spannung als auch mindestens einer gemessenen Temperatur ein Kennwert gebildet, der für einen Zustand des Speichersystems charakteristisch ist. Bei diesem Kennwert kann es sich beispielsweise um einen Kennwert handeln, der für eine Lebenserwartung eines bestimmten Moduls oder auch des gesamten Speichersystems charakteristisch ist.

Bevorzugt wird wenigstens ein Betriebsparameter des Speichersystems unter Berücksichtigung des Kennwerts gesteuert. So ist es beispielsweise möglich, dass nach der Bildung oder Bestimmung der oben erwähnten Zustandsgröße bzw. des Kennwerts aus Temperaturzustand und Modulsymmetrie das Antriebssystem dynamisch an die Funktionsfähigkeit (SOF = State of Function) des EDLC Speichersystems angepasst wird.

Erfindungsgemäß werden für wenigstens ein Modul Zeitspannen ermittelt, in denen sich dieses Modul in einem vorgegebenen Spannungsbereich und in einem vorgegebenen Temperaturbereich befindet. Genauer gesagt werden zur Bestimmung der Lebenserwartung (SOH) in einen Spannungs- und Temperaturcluster pro Modul die jeweiligen Verweilzeiten gebildet. Auf diese Weise kann die Alterung bzw. eine zu erwartende Lebensdauer des betreffenden Moduls abgeschätzt werden.

Vorzugsweise werden die Zeitspannen unterschiedlicher Module miteinander verglichen. So können beispielsweise Unsymmetrien der jeweiligen Verweilzeiten im jeweiligen Spannungs- und Temperaturcluster der Einzelmodule zur Abschätzung der Funktionsfähigkeit und des vorzeitigen Modulausfalls herangezogen werden. Beispielsweise könnten für drei verschiedene Module drei entsprechende Cluster gebildet werden und die einzelnen Werte dieser Cluster miteinander verglichen werden. Falls in einem einzelnen Cluster bestimmte Werte über einen Toleranzbereich hinaus von Sollwerten abweichen, kann dies als Indiz für einen baldigen Ausfall des betreffenden Moduls gewertet werden.

Bei einem weiteren vorteilhaften Verfahren wird in Reaktion auf einen Vergleich der Zeitspannen ein Ladezustand des Speichersystems verändert. So ist es beispielsweise möglich, dass, falls Unsymmetrien erkannt werden, über das Antriebssystem der Ladezustand des EDLC Speichersystems so beeinflusst wird, dass ab einem bestimmten Spannungsgrenzwert aktive Zellsymmetrierungen ansprechen bzw. aktiv zu schaltende Symmetrieeinrichtungen direkt angesteuert werden und somit Spannungsunterschiede gezielt abgebaut werden.

Weitere vorteilhafte Ausführungsformen ergeben sich aus den beigefügten Zeichnungen:
Darin zeigen:
- Fig. 1: Eine blockdiagrammartige Darstellung eines erfindungsgemäßen Speichersystems;
- Fig. 2: Einen Spannungs- Temperaturcluster für ein Modul.

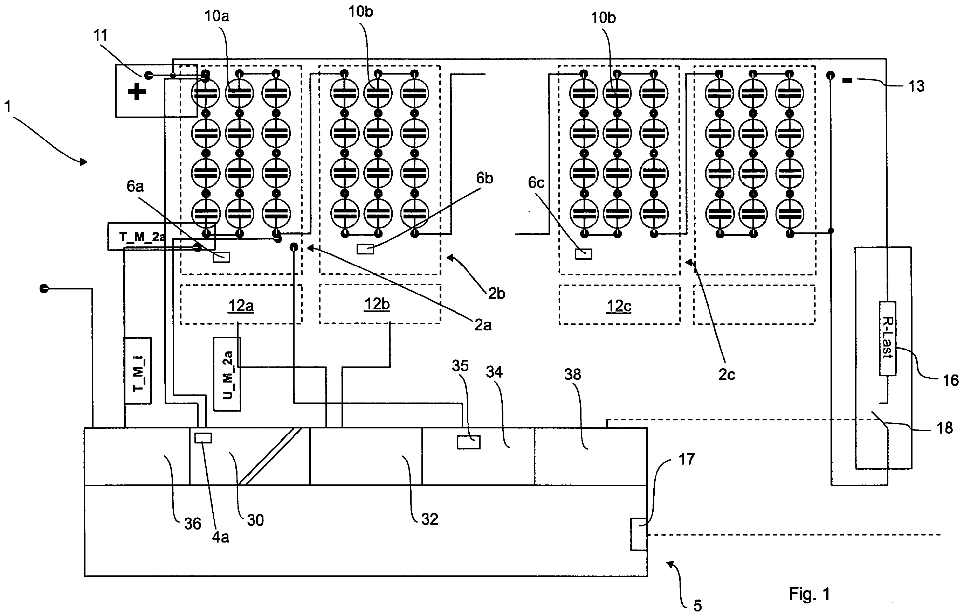

Fig. 1 zeigt eine blockdiagrammartige Darstellung eines erfindungsgemäßen Speichersystems 1. Dieses Speichersystem 1 weist eine Vielzahl von Doppelschichtkondensatoren 10a, 10b, 10c auf. Dabei sind diese Doppelschichtkondensatoren 10a, 10b, 10c in einer Reihe geschaltet zwischen einem Pluspol 11 und einem Minuspol 13. Die einzelnen Doppelschichtkondensatoren sind dabei auf eine Vielzahl von Modulen 2a, 2b, 2c aufgeteilt.

Das Bezugszeichen 30 bezieht sich auf eine Spannungserfassungseinheit, wobei mit Hilfe einer Spannungsmesseinrichtung 4a beispielsweise die an dem Modul 2a anliegende Spannung gemessen wird. Entsprechend werden auch über (nicht gezeigt) Spannungsmesseinrichtungen die Spannungen an den weiteren Modulen 2b, 2c... gemessen. Damit kann getrennt für die einzelnen Module jeweils die an diesem Modulen anliegende Spannung insbesondere auch im Betrieb gemessen werden. Die jeweiligen Verbindungsleitungen zwischen den Modulen und der Spannungserfassungseinrichtung sind jeweils nur für das Modul 2a dargestellt, um auf diese Weise die Übersichtlichkeit der Darstellung zu erhöhen.

Das Bezugszeichen 5 bezieht sich auf in seiner Gesamtheit auf eine Überwachungseinrichtung für das Speichersystem, welche neben der bereits beschriebenen Spannungserfassungseinheit 30 auch eine Temperaturerfassungseinheit 36, eine Ansteuerungseinheit 32 für Kühlungen, eine optimale Ansteuerung 34 für Spannungssymmetrierung und eine optimale Ansteuerung für einen Lastwiderstand 16 aufweist. Mit Hilfe der Temperaturerfassungseinheit 36 werden jeweils Temperaturen T_M_i der einzelnen Module gemessen, wobei hier die Messung einer Temperatur T_M_2a dargestellt ist, welche mit Hilfe einer Temperaturmesseinrichtung 6a an dem betreffenden Modul 2a gemessen wird. Die Leitungsverbindungen zwischen der Überwachungseinrichtung 5 und den weiteren Modulen 2b, 2c,... sind aus Gründen der Übersichtlichkeit nicht dargestellt

Die Bezugszeichen 12a, 12b, 12c beziehen sich auf unabhängig voneinander steuerbare Kühleinrichtungen zum Kühlen der einzelnen Module 2a, 2b, 2c. Über die Kühlungsansteuerung 32 werden diese einzelnen Kühleinrichtungen 12a, 12b, 12c gesteuert und zwar insbesondere auch unter Berücksichtigung von gemessenen Temperaturwerten T_M_i bzw. Spannungswerten U_M_i.

Über die Steuerung 38 kann eine Schalteinrichtung 18 betätigt werden, mit der ein Lastwiderstand 16 an sämtliche Module 2a, 2b, 2c angelegt werden kann. Wie oben erwähnt, kann durch Zuschalten dieses Lastwiderstands 16 gezielt ein Laststrom erzeugt werden.

Das Bezugszeichen 17 bezieht sich auf eine Schnittstelle bzw. eine Kommunikationsverbindung zu einem Antriebssystem (z.B. CAN). Durch diese Ansteuerung kann gezielt in Abhängigkeit von Zuständen der Doppelschichtkondensatoren auch der Antrieb angesteuert werden.

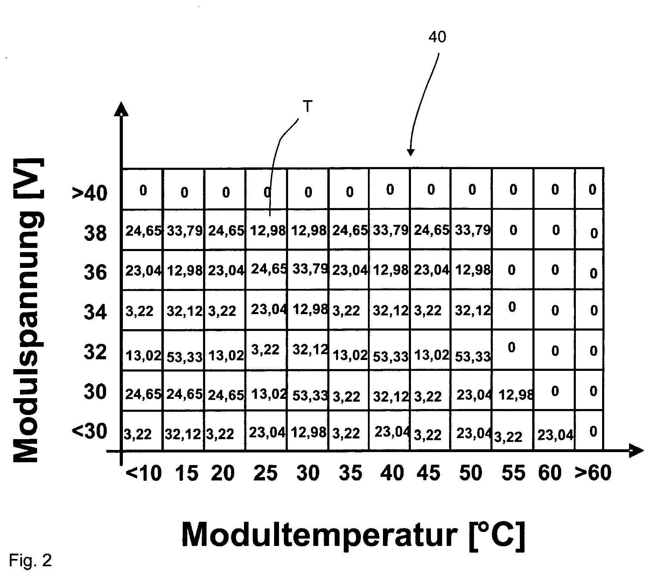

Fig. 2 zeigt eine Darstellung zur Veranschaulichung der oben erwähnten Clusterbildung. Im einzelnen werden hier Cluster aus Modultemperaturbereichen und Modulspannungen für jedes einzelne Modul gebildet. Dabei bezieht sich das Bezugszeichen T auf Verweilzeiten des Moduls in einem bestimmten Cluster. So beträgt beispielsweise bei einer Modulspannung von 38 V und einer Modultemperatur von 40°C hier die Verweilzeit des Moduls 33,79 Stunden. Zur Auswertung können die einzelnen Werte mit den entsprechenden Werten weiterer Module verglichen werden. Falls beispielsweise bei einem anderen Modul der Wert für eine Modulspannung von 38 V und eine Modultemperatur von 40°C deutlich von dem hier angezeigten Wert von 33,79 Stunden abweicht, so kann hieraus auf die Funktionsfähigkeit des betreffenden Moduls und einem vorzeitigen Modulausfall geschlossen werden.

Bevorzugt werden jedoch, wie oben erwähnt, diese Cluster 40 für sämtliche Module gebildet, so dass auf diese Weise leichter Durchschnittswerte bzw. Abweichungen von diesen Durchschnittswerten für die einzelnen Module notiert werden können. Anstelle der in Fig. 2 gezeigten Darstellung könnte jedoch auch eine andere graphische Darstellung folgen, welche sämtliche Module berücksichtigt, um auf diese Weise leichter Abweichungen einzelner Module zu erkennen.

### Bezugszeichenliste

- 1: Speichersystem
- 2a,b,c: Vielzahl von Modulen
- 4a: Spannungsmesseinrichtung
- 5: Überwachungseinrichtung
- 6a: Temperaturmesseinrichtung
- 12a,b,c: steuerbare Kühleinrichtung
- 16: Lastwiderstand
- 17: Schnittstelle
- 18: Schalteinrichtung
- 30: Spannungseinheit
- 32: Kühlungsansteuerungseinheit
- 34: Ansteuerung
- 36: Temperaturerfassungseinheit
- 38: Steuerung
- 40: Cluster
- T: Verweilzeit

## Patentansprüche

1. Elektrisches Speichersystem (1) mit einer Vielzahl von elektrischen Doppelschichtkondensatoren (10a, 10b, 10c), die elektrisch miteinander verbunden sind und mit einer Überwachungseinrichtung (5) zum Überwachen wenigstens eines physikalischen Zustands der Doppelschichtkondensatoren (10a, 10b, 10c),
wobei
das Speichersystem (1) in mehrere Module (2a, 2b, 2c) segmentiert ist, wobei jedes dieser Module (2a, 2b, 2c) eine Vielzahl von elektrisch miteinander verbundenen Doppelschichtkondensatoren (10a, 10b, 10c) aufweist und die Überwachungseinrichtung (4) eine Vielzahl von Spannungsmesseinrichtungen (4a) aufweist, wobei jedes Modul (2a, 2b, 2c) mit wenigstens einer Spannungsmesseinrichtung (4a) in Verbindung steht, welche einen Spannungszustand dieses Moduls (2a, 2b, 2c) bestimmt, **dadurch gekennzeichnet, dass** das elektrische Speichersystem (1) dazu ausgebildet ist:
für wenigstens ein Modul (2a, 2b, 2c) Zeitspannen (T1, T2,..Tn) zu ermitteln, in denen sich dieses Modul in einem vorgegebenen Spannungsbereich und in einem vorgegebenen Temperaturbereich befindet, und auf Grundlage der Zeitspannen (T1, T2, ... Tn) eine verbleibende Lebensdauer des entsprechenden Moduls zu ermitteln.

2. Elektrisches Speichersystem (1) nach Anspruch 1,
**dadurch gekennzeichnet, dass**
das Speichersystem (1) eine Vielzahl von Temperaturmesseinrichtungen (6a, 6b, 6c) aufweist, wobei jedem Modul wenigstens eine Temperaturmesseinrichtung (6a, 6b, 6c) zugeordnet ist, welche eine für das Modul (2a, 2b, 2c) charakteristische Temperatur misst.

3. Elektrisches Speichersystem (1) nach wenigstens einem der vorangegangenen Ansprüche,
**dadurch gekennzeichnet, dass**
das Speichersystem (1) eine Vielzahl von unabhängig voneinander steuerbaren Kühleinrichtungen (12a, 12b, 12c) aufweist, wobei jedem Modul (2a, 2b, 2c) wenigstens eine Kühleinrichtung (12a, 12b, 12c) zu deren Kühlung zugeordnet ist.

4. Elektrisches Speichersystem (1) nach Anspruch 2,
**dadurch gekennzeichnet, dass**
das Speichersystem (1) eine Prozessoreinrichtung (36) aufweist, welche aus einer Vielzahl von von den Temperaturmesseinrichtungen (6a, 6b, 6c) ausgegebenen Temperaturwerten wenigstens eine Kennwert für das Speichersystem (1) oder einzelne Module (2a, 2b, 2c) ermittelt.

5. Elektrisches Speichersystem (1) nach wenigstens einem der vorangegangenen Ansprüche 3 - 4,
**dadurch gekennzeichnet, dass** eine Steuereinrichtung (30) vorgesehen ist, welche die Kühleinrichtungen (12a, 12b, 12c) in Abhängigkeit von von den Temperaturmesseinrichtungen (6a, 6b, 6c) ausgegebenen Werten steuert.

6. Elektrisches Speichersystem (1) nach wenigstens einem der vorangegangenen Ansprüche,
**dadurch gekennzeichnet, dass**
das Speichersystem (1) eine Spannungssymmetrierungseinrichtung (35) aufweist.

7. Elektrisches Speichersystem (1) nach wenigstens einem der vorangegangenen Ansprüche,
**dadurch gekennzeichnet, dass**
das Speichersystem (1) einen an die Gesamtheit der Module (2a, 2b, 2c) zuschaltbaren Verbraucher (16) aufweist.

8. Elektrisches Speichersystem (1) nach wenigstens einem der vorangegangenen Ansprüche,
**dadurch gekennzeichnet, dass** das elektrische Speichersystem (1) dazu ausgebildet ist:
über einen zuschaltbaren Verbraucher gezielt einen Leistungssprung zu erzeugen und über den dadurch verursachten Spannungsabfall in den einzelnen Modulen für jedes Modul den jeweiligen Innenwiderstand und die Kapazität zu ermitteln, wobei der jeweilige Innenwiderstand und die Kapazität herangezogen werden, um eine Lebenserwartung des jeweiligen Moduls zu ermitteln.

9. Verfahren zum Steuern eines elektrischen Speichersystems (1) nach wenigstens einem der vorangegangenen Ansprüche,
**dadurch gekennzeichnet, dass**
mehrere an unterschiedlichen Modulen (2a, 2b, 2c) anliegende Spannungen (U_M_2a, U_M_2b, U_M_2c) gemessen werden und unter Berücksichtigung dieser Spannungen (U_M_2a, U_M_2b, U_M_2c) wenigstens ein Betriebsparameter des Speichersystems (1) gesteuert wird.

10. Verfahren nach Anspruch 9,
**dadurch gekennzeichnet, dass**
die Temperaturen (T_M_2a, T_M_2b, T_M_2c) mehrerer Module gemessen werden und unter Berücksichtigung dieser Temperaturen (T_M_2a, T_M_2b, T_M_2c) wenigstens ein Betriebsparameter des Speichersystems (1) gesteuert wird.

11. Verfahren nach wenigstens einem der vorangegangenen Ansprüche,
**dadurch gekennzeichnet, dass**
unter Berücksichtigung sowohl mindestens einer Spannung (U_M_2a, U_M_2b, U_M_2c) als auch mindestens einer gemessenen Temperatur (T_M_2a, T_M_2b, T_M_2c) ein Kennwert (K) gebildet wird, der für einen Zustand des Speichersystems (1) charakteristisch ist.

12. Verfahren nach Anspruch 11,
**dadurch gekennzeichnet, dass** wenigstens ein Betriebsparameter des Speichersystems (1) unter Berücksichtigung des Kennwerts (K) gesteuert wird.

13. Verfahren nach einem der vorherigen Ansprüche,
**dadurch gekennzeichnet, dass** Zeitspannen unterschiedlicher Module (2a, 2b, 2c) miteinander verglichen werden.

14. Verfahren nach einem der vorherigen Ansprüche,
**dadurch gekennzeichnet, dass**
in Reaktion auf einen Vergleich der Zeitspannen (T1, T2..) ein Ladezustand des Speichersystems (1) verändert wird.

## Claims

1. An electrical storage system (1) having a plurality of electrical double layer capacitors (10a, 10b, 10c), which are electrically connected to one another and to a monitoring device (5) for monitoring at least one physical state of the double layer capacitors (10a, 10b, 10c),
wherein
the storage system (1) is segmented into a plurality of modules (2a, 2b, 2c), wherein each of said modules (2a, 2b, 2c) has a plurality of double layer capacitors (10a, 10b, 10c) that are electrically connected to one another and the monitoring device (4) has a plurality of voltage measurement devices (4a), wherein each module (2a, 2b, 2c) is connected to at least one voltage measurement device (4a), which determines a voltage state of said module (2a, 2b, 2c),
**characterized in that** the electrical storage system (1) is designed:
to identify time periods (T1, T2, ... Tn) for at least one module (2a, 2b, 2c), in which time periods said module is situated in a prescribed voltage range and in a prescribed temperature range, and to identify a remaining lifetime of the corresponding module based on the time periods (T1, T2, ... Tn) .

2. The electrical storage system (1) according to Claim 1,
**characterized in that**
the storage system (1) has a plurality of temperature measurement devices (6a, 6b, 6c), wherein at least one temperature measurement device (6a, 6b, 6c) is assigned to each module, said temperature measurement device measuring a temperature that is characteristic of the module (2a, 2b, 2c).

3. The electrical storage system (1) according to at least one of the preceding claims,
**characterized in that**
the storage system (1) has a plurality of cooling devices (12a, 12b, 12c) that are able to be controlled independently of one another, wherein at least one cooling device (12a, 12b, 12c) is assigned to each module (2a, 2b, 2c) for the cooling thereof.

4. The electrical storage system (1) according to Claim 2,
**characterized in that**
the storage system (1) has a processor device (36), which identifies at least one characteristic value for the storage system (1) or individual modules (2a, 2b, 2c) from a plurality of temperature values output by the temperature measurement devices (6a, 6b, 6c).

5. The electrical storage system (1) according to at least one of the preceding Claims 3-4,
**characterized in that** a control device (30) is provided, which controls the cooling devices (12a, 12b, 12c) depending on values output by the temperature measurement devices (6a, 6b, 6c).

6. The electrical storage system (1) according to at least one of the preceding claims,
**characterized in that**
the storage system (1) has a voltage balancing device (35) .

7. The electrical storage system (1) according to at least one of the preceding claims,
**characterized in that**
the storage system (1) has a consumer (16) that is able to be connected to the entirety of the modules (2a, 2b, 2c) .

8. The electrical storage system (1) according to at least one of the preceding claims,
**characterized in that** the electrical storage system (1) is designed:
to generate a jump in power in a targeted manner by means of a connectable consumer and to identify the respective internal resistance and the capacitance for each module by means of the voltage drop in the individual modules caused thereby, wherein the respective internal resistance and the capacitance are used to identify a life expectancy of the respective module.

9. A method for controlling an electrical storage system (1) according to at least one of the preceding claims,
**characterized in that**
a plurality of voltages (U_M_2a, U_M_2b, U_M_2c) applied to different modules (2a, 2b, 2c) are measured and at least one operating parameter of the storage system (1) is controlled taking into account said voltages (U_M_2a, U_M_2b, U_M_2c).

10. The method according to Claim 9,
**characterized in that**
the temperatures (T_M_2a, T_M_ 2b, T_M_2c) of a plurality of modules are measured and at least one operating parameter of the storage system (1) is controlled taking into account said temperatures (T_M_2a, T_M_2b, T_M_2c).

11. The method according to at least one of the preceding claims,
**characterized in that**
a characteristic value (K) is formed taking into account both at least one voltage (U_M_2a, U_M_2b, U_M_2c) and at least one measured temperature (T_M_2a, T_M_2b, T_M_2c), said characteristic value being characteristic of a state of the storage system (1).

12. The method according to Claim 11,
**characterized in that** at least one operating parameter of the storage system (1) is controlled taking into account the characteristic value (K).

13. The method according to one of the preceding claims,
**characterized in that** time periods of different modules (2a, 2b, 2c) are compared with one another.

14. The method according to one of the preceding claims,
**characterized in that**
a state of charge of the storage system (1) is changed in response to a comparison of the time periods (T1, T2, ...).

## Revendications

1. Système de stockage électrique (1) doté d'une pluralité de condensateurs à double couche (10a, 10b, 10c), lesquels sont reliés électriquement les uns aux autres et doté d'un dispositif de contrôle (5) destiné à contrôler au moins un état physique des condensateurs à double couche (10a, 10b, 10c),
le système de stockage (1) étant segmenté en plusieurs modules (2a, 2b, 2c), chacun de ces modules (2a, 2b, 2c) comportant une pluralité de condensateurs à double couche (10a, 10b, 10c) reliés électriquement les uns aux autres et le dispositif de contrôle (4) comportant une pluralité de dispositifs de mesure de tension (4a), chaque module (2a, 2b, 2c) étant en raccordement avec au moins un dispositif de mesure de tension (4a), lequel détermine un état de tension de ce module (2a, 2b, 2c), **caractérisé en ce que** le système de stockage électrique (1) est réalisé de façon à :
déterminer des périodes (T1, T2, ..., Tn) pour au moins un module (2a, 2b, 2c), pendant lesquelles ce module se trouve dans un intervalle de tension prédéfini et un intervalle de température prédéfini, et déterminer une durée de vie restante du module correspondant en se basant sur les périodes (T1, T2, ..., Tn).

2. Système de stockage électrique (1) selon la revendication 1, **caractérisé en ce que** le système de stockage (1) comporte une pluralité de dispositifs de mesure de température (6a, 6b, 6c), dans lequel au moins un dispositif de mesure de température (6a, 6b, 6c) est ordonné à chaque module, lequel mesure une température caractéristique pour le module (2a, 2b, 2c).

3. Système de stockage électrique (1) selon au moins une des revendications précédentes, **caractérisé en ce que** le système de stockage (1) comporte une pluralité de dispositifs de refroidissement (12a, 12b, 12c) commandables indépendamment l'un de l'autre, dans lequel au moins un dispositif de refroidissement (12a, 12b, 12c) est ordonné à chaque module (2a, 2b, 2c) pour le refroidissement de celui-ci.

4. Système de stockage électrique (1) selon la revendication 2, **caractérisé en ce que** le système de stockage (1) comporte un dispositif de processeur (36), lequel détermine au moins une valeur caractéristique pour le système de stockage (1) ou des modules individuels (2a, 2b, 2c) à partir d'une pluralité de valeurs de température émises par les dispositifs de mesure de température (6a, 6b, 6c).

5. Système de stockage électrique (1) selon au moins une des revendications précédentes 3-4, **caractérisé en ce qu'**un dispositif de commande (30) est prévu, lequel commande les dispositifs de refroidissement (12a, 12b, 12c) en fonction des valeurs émises par les dispositifs de mesure de température (6a, 6b, 6c).

6. Système de stockage électrique (1) selon au moins une des revendications précédentes, **caractérisé en ce que** le système de stockage (1) comporte un dispositif de symétrisation de tension (35).

7. Système de stockage électrique (1) selon au moins une des revendications précédentes, **caractérisé en ce que** le système de stockage (1) comporte un récepteur (16) commutable à la totalité des modules (2a, 2b, 2c).

8. Système de stockage électrique (1) selon au moins une des revendications précédentes, **caractérisé en ce que** le système de stockage (1) est réalisé de façon à : produire intentionnellement un saut de puissance par le biais d'un récepteur commutable et déterminer pour chaque module la résistance interne et la capacité respectives par le biais de la chute de tension ainsi obtenue dans le module individuel, dans lequel la résistance interne et la capacité respectives sont utilisées pour déterminer une espérance de vie du module respectif.

9. Procédé de commande d'un système de stockage électrique (1) selon au moins une des revendications précédentes, **caractérisé en ce que** plusieurs tensions (U_M_2a, U_M_2b, U_M_2c) appliquées aux bornes des différents modules (2a, 2b, 2c) sont mesurées et au moins un paramètre opérationnel du système de stockage (1) est commandé compte tenu de ces tensions (U_M_2a, U_M_2b, U_M_2c).

10. Procédé selon la revendication 9, **caractérisé en ce que** les températures (T_M_2a, T_M_2b, T_M_2c) de plusieurs modules sont mesurées et au moins un paramètre opérationnel du système de stockage (1) est commandé compte tenu de ces températures (T_M_2a, T_M_2b, T_M_2c).

11. Procédé selon au moins une des revendications précédentes, **caractérisé en ce qu'**une valeur caractéristique (K), laquelle est caractéristique pour un état du système de stockage (1), est formée compte tenu d'au moins une tension (U M_2a, U_M_2b, U M_2c) et d'au moins une température mesurée (T_M_2a, T_M_2b, T_M_2c).

12. Procédé selon la revendication 11, **caractérisé en ce qu'**au moins un paramètre opérationnel du système de stockage (1) est commandé compte tenu de la valeur caractéristique (K).

13. Procédé selon l'une des revendications précédentes, **caractérisé en ce que** les périodes de différents modules (2a, 2b, 2c) sont comparées les unes aux autres.

14. Procédé selon l'une des revendications précédentes, **caractérisé en ce qu'**un état de charge du système de stockage (1) est modifié en réaction à une comparaison des périodes (T1, T2...) .
